# EUROPEAN PATENT APPLICATION

(11) **EP 1 830 363 A1**
(43) Date of publication of application: **05.09.2007**
(21) Application number: 04807679.8
(22) Date of filing: 24.12.2004
(51) Int. Cl.: G11C 11/407

(54) **SYNCHRONIZATION TYPE STORAGE DEVICE AND CONTROL METHOD THEREOF**

(71) Applicant: Spansion LLc, Santa Clara CA 95054 (US); Spansion Japan Limited, Aizuwakamatsu-shi, Fukushima 965-0845 (JP)
(72) Inventor: SHIMBAYASHI, Koji, c/o SPANSION JAPAN LIMITED, Aizuwakamatsu-shi, Fukushima 965-0845 (JP)
(74) Representative: Grünecker, Kinkeldey, Stockmair & Schwanhäusser Anwaltssozietät
(86) International application number: PCT/JP2004/019322
(87) International publication number: WO 2006/067852

(57) **Abstract**

In DDR mode, (L-1) count signal BRDYB is inverted to low level when 1 is subtracted from initial latency (L=3). As a result, a delayed signal S (N1BD)/S (N1D) in reverse phase to signal S (N1)/S (N1B) is issued, and internal clock CKI becomes high level during high level period of the two. This is operated in synchronization with both edges of external clock CLK, and output of double frequency is started. In external clock cycle immediately before completion of counting of initial latency in count period of initial latency, the internal clock CKI is changed over to double frequency. Validity flag RDY is changed to high level in second cycle of double frequency.

## Description

### TECHNICAL FIELD

The present invention relates to a synchronous storage device usable by changing over single data rate mode and double data rate mode, and its control method, and also to a synchronous storage device of double data rate mode, and its control method.

### BACKGROUND ART

In the synchronous semiconductor memory device disclosed in patent document 1, a circuit shown in Fig. 9 is used as control pulse generating circuit. It comprises internal clock generator 150, frequency divider 152, selector 153, etc.

The internal clock generator 150 receives external system clock CLK, and generates internal clock PCLK_DDR for DDR mode having same frequency as the external system clock CLK. The frequency divider 152 receives this internal clock PCLK_DDR for DDR mode, divides it in frequency, and generates internal clock PCKL_SDR for SDR mode having half frequency of internal clock PCLK_DDR for DDR mode.

The selector 153, in response to mode control signal /DDR, selects either one of internal clock PCLK_DDR for DDR mode and internal clock PCLK_SDR for SDR mode, and issues it as internal clock.

When operating in DDR mode, mode control signal /DDR has low level. At this time, a transmission switch 154 of the selector 153 is turned on in response to mode control signal /DDR and mode control signal /DDR inverted by an inverter 158, while a transmission switch 156 is turned off. Therefore, internal clock PCLK_DDR for DDR mode is issued as internal clock PCLK.

When operating in SDR mode, mode control signal /DDR has high level. At this time, the transmission switch 154 of the selector 153 is turned off, and the transmission switch 156 is turned on, and internal clock PCLK_SDR for SDR mode is issued as internal clock PCLK.
Patent document 1: Japanese unexamined patent publication No. H11 (1999)-213668

### DISCLOSURE OF THE INVENTION

### PROBLEMS TO BE SOLVED BY THE INVENTION

In the configuration in patent document 1, the internal clock PCLK_DDR for DDR mode generated by the internal clock generator 150, and the internal clock PCLK_SDR for SDR mode issued from the frequency divider 152 are selected by the selector 153, and internal clock PCLK is issued. In the selector 153, depending on the mode control signal /DDR and signal from the inverter 158 issuing its inverted signal, either one of the transmission switches 154, 156 is turned on, and the other is turned off.

However, to change over the operation mode between SDR mode and DDR mode, it depends on transition of logic level in mode control signal /DDR, but since operation delay may occur in the inverter 158, and transmission switches 154, 156, a time delay may occur from transition of mode control signal /DDR to changeover of internal clock PCLK.

In patent document 1, depending on internal clock PCLK, counting of latency and generation of various flags are controlled. In this case, it is required to control the internal clock PCLK operating at double frequency by DDR mode, and the load may be increased in the circuit configuration for handling high speed clock.

### MEANS FOR SOLVING THE PROBLEMS

The invention is devised in the light of the background art disclosed herein, relating to a synchronous storage device having SDR mode and DDR mode, and operating by changing over these two operation modes, and it is hence an object thereof to present a synchronous storage device capable of easily changing over the operation modes, and realizing stable DDR mode operation easily, and its control method.

A synchronous storage device according to a first aspect of the invention attempted to achieve the object stated above is capable of changing over between a first operation mode for accessing in synchronism with either edge of a pulse of an external clock signal and a second operation mode for accessing in synchronism with both edges of a pulse of the external clock signal, the synchronous storage device comprising an L-n detector for counting pulses of the external clock signal while counting the initial latency (L) from start of accessing, and detecting the number of pulses of the external clock signal (L-n) by subtracting n, wherein n is a numerical value of 1 or greater in increments of 0.5, from the initial latency (L), and an internal clock generator coupled to the L-n detector for changing over an internal clock from a first clock signal for synchronizing with either edge of a pulse of the external clock signal to a second clock signal for synchronizing with both edges of a pulse of the external clock signal, depending on the detected signal from the L-n detector when the second operation mode is being set.

In the synchronous storage device of the first aspect of the invention, when measuring the initial latency (L) by counting pulses of the external clock signal by (L-n) detector, the number of pulses of the external clock signal (L-n) subtracting n from the initial latency (L) are detected, and when second operation mode is set, the internal clock is changed over from first clock synchronized with either one edge of external clock to second clock synchronized with both edges of external clock, depending on the detection signal of number of pulses (L-n), by the internal clock generator.

A control method of the synchronous storage device of the first aspect of the invention is capable of switching between a first operation mode for accessing in synchronism with either edge of an external clock signal and a second operation mode for accessing in synchronism with both edges of the external clock signal, the control method comprising the steps of detecting the number of clock signals (L-n), by subtracting n (n having a numerical value of 1 or higher at increments of 0.5) from the initial latency (L), about the external clock signal, the initial latency (L) being counted from start, and in the second operation mode, changing over the internal clock from a first clock signal for synchronizing with either edge of the external clock signal to a second clock signal for synchronizing with both edges of the external clock signal in response to the step of detecting the number of clock signals (L-n).

In the control method of synchronous storage device of the first aspect of the invention, when measuring the initial latency (L) by counting pulses of the external clock signal, the number of pulses of the external clock signal (L-n) subtracting n from the initial latency (L) are counted, and when second operation mode is set, the internal clock is changed over from first clock synchronized with either one edge of external clock to second clock synchronized with both edges of external clock, depending on the detection of number of pulses (L-n).

Accordingly, whether in first or second operation mode, depending on counting of the number of pulses (L-n) in the counting period of initial latency (L) counted at one edge of external clock, the internal clock is changed over from first clock as internal clock in first operation mode to second clock as internal clock in second operation mode. In the counting period of initial latency (L), the changeover operation of internal clock from first operation mode to second operation mode can be included, and any extra period is not needed for changeover of internal clock. It is not required to reserve changeover time for changing over the operation mode, and operation mode changeover without time delay can be realized. It hence presents a synchronous storage device capable of changing over the operation mode easily from first operation mode to second operation mode, and its control method.

A synchronous storage device of a second aspect of the invention for accessing in synchronism with both edges of an external clock comprising a basic clock generator for issuing a pulse signal in response to a signal synchronizing with one edge of the external clock and a delayed signal in reverse phase to the signal, a half-period notice unit for issuing a half-period signal by noticing the timing of a half period from one edge of the external clock, and a first intermediate clock generator for issuing a pulse signal in response to the half-period signal and a delayed signal in reverse phase to the half-period signal, wherein a second clock signal is generated in response to the pulse signals issued from the basic clock generator and the first intermediate clock generator.

In the synchronous storage device of the second aspect of the invention, a basic clock generator issues a pulse signal depending on the signal synchronized with either one edge of external clock and a delayed signal in reverse phase to this signal, and a first clock in first operation mode is generated. Further, a first internal clock generator issues a pulse signal depending on half-period signal and a delayed signal in reverse phase to this half-period signal, and a second clock in second operation mode is generated, together with pulse signal from the basic clock generator. Herein, the half-period signal is a signal noticed by a half-period notice unit, and showing the timing of half period from either one edge of external clock.

A control method of the synchronous storage device of the second aspect of the invention for accessing in synchronism with both edges of an external clock, the control method comprising the steps of obtaining an internal clock signal by generating a pulse signal depending on a signal synchronizing with one edge of the external clock and a delayed signal in reverse phase to the signal, noticing the timing of a half period from one edge of the external clock, and generating a pulse signal and adding to the internal clock signal in response to a signal obtained at the step of noticing the timing of the half period and a delayed signal in reverse phase to the signal.

In the control method of synchronous storage device of the second aspect of the invention, a pulse signal is issued depending on the signal synchronized with either one edge of external clock and a delayed signal in reverse phase to this signal, and a first clock in first operation mode is generated. Further, a pulse signal is issued depending on half-period signal and a delayed signal in reverse phase to this half-period signal, and a second clock in second operation mode is generated, together with pulse signal from the first clock generator. Herein, the half-period signal is a signal noticed by a half-period notice unit, and showing the timing of half period from either one edge of external clock.

Accordingly, even if the time interval between the both edges is not uniform although the period of external clock is accurate, since the timing of half period from either one edge of external clock is accurately noticed by the half-period signal, second clock having double frequency of first clock can be generated precisely on the basis of either one edge of external clock. When operating in second operation mode, too, two operations conducted in one period of external clock can be distributed in uniform time interval, and set-up time and hold time in each operation can be reserved to maximum extent.

### EFFECTS OF THE INVENTION

According to the synchronous storage device and its control method of the invention, in the synchronous storage device having first operation mode and second operation mode, and operating by changing over these two operation modes, changeover of internal clock when changing over operation modes can be included in the count operation period of initial latency (L), and extra time for changing over internal clock is not needed. Besides, second clock in second operation mode can be generated precisely. Stable operation and operation mode changeover can be realized easily.

### BRIEF DESCRIPTION OF THE DRAWINGS

Fig. 1 is a circuit block diagram of synchronous storage device of the invention common to first and second embodiments;
Fig. 2 is a circuit diagram of validity flag (RDY) output unit common to first and second embodiments;
Fig. 3 is a circuit diagram of internal clock generator in first embodiment;
Fig. 4 is a waveform diagram showing operation in SDR mode in internal clock generator in Fig. 3;
Fig. 5 is a waveform diagram showing operation in DDR mode in internal clock generator in Fig. 3;
Fig. 6 is a circuit diagram of internal clock generator in second embodiment;
Fig. 7 is a diagram showing setting in each operation mode in internal clock generator in Fig. 3;
Fig. 8 is a waveform diagram showing mode of generation of second clock on the basis of half-period signal (NPS) in internal clock generator in Fig. 3; and
Fig. 9 is a circuit diagram disclosed in patent document 1.

### BEST MODE FOR CARRYING OUT THE INVENTION

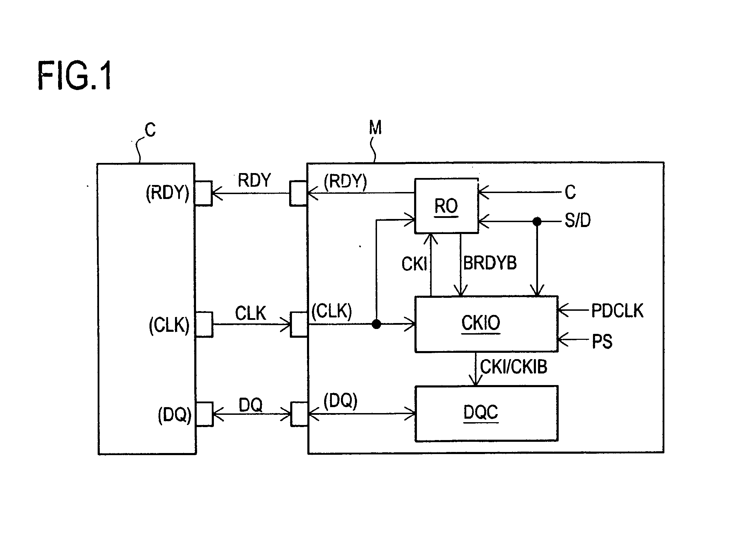

First and second embodiments specifically representing the synchronous storage device and its control method of the invention are described in detail below while referring to the drawings in Fig. 1 to Fig. 8.

In nonvolatile storage device such as flash memory, or in volatile storage device such as DRAM, SRAM, etc., data is read out synchronously with external clock CLK disclosed in Fig. 1, and such storage device has operation specification of so called synchronous storage device M. In the synchronous storage device M, at every clock cycle in stationary state, data is read out from different addresses sequentially. Generally, external clock CLK is high in speed, and in order to read out data at every cycle in high speed clock cycle, before start of reading operation, internal pre-processing of read data must be finished, such as amplification of data from plural memory cells.

As the time for such pre-processing, initial latency (L) after start is set. The initial latency (L) is generally set by the number of clocks of external clock CLK after start command (/AVD, etc.) for incorporating external address. When the external clock CLK passes the number of clocks set as initial latency (L), internal pre-processing of read data is finished, and after passing the initial latency (L), output of data DQ is enabled. It is controlled by data input and output control unit DQC. By the output of data validity flag noticing completion of internal pre-processing of data DQ to outside, together with the count of the number of clocks of external clock CLK, or instead of the count of the number of clocks, the memory controller or other system C side acknowledges that the output data DQ is valid data. In particular, this flag is necessary when the number of clocks of external clock CLK is not counted in the system C receiving the data DQ issued from the synchronous storage device M.

The data validity flag herein is a signal issued from RDY terminal (RDY) shown in Fig. 1 in a nonvolatile storage device such as flash memory. It is the validity flag (RDY) output unit that issues this data validity flag RDY. The system C side monitors the logical level of the signal at RDY terminal (RDY), and can judge whether the data DQ issued from the data terminal (DQ) is valid data or not. In the count period of initial latency (L), the data validity flag is issued after (L-1)-th clock and before L-th clock.

The external clock CLK is put into an internal clock generator, and internal clocks CKI, CKIB are generated. The internal clocks CKI, CKIB are supplied into validity flag (RDY) output unit RO, and data input and output control unit DQC.

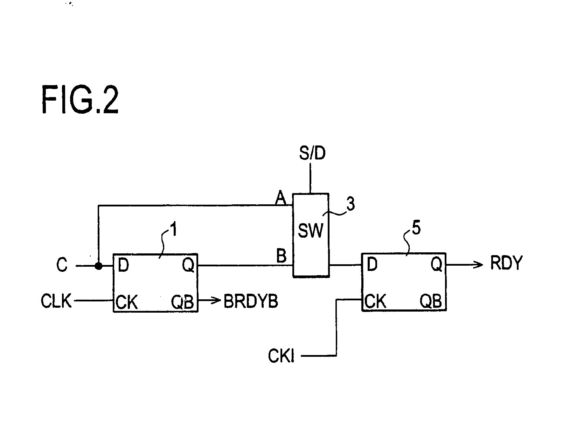

The circuit diagram in Fig. 2 shows a circuit example of validity flag (RDY) output unit. This circuit example is applied in both first and second embodiments described below.

A flip-flop circuit 1 becomes high level as the counter circuit not shown for counting the number of clocks of external clock CLK notices counting of the number of (L-2) clocks subtracting 2 from the initial latency (L). The (L-2) count signal C is put into input terminal D. External clock CLK is fed in clock terminal CK. Therefore, from output terminals Q and QB, one clock cycle behind, in-phase signal with (L-2) count signal C and reverse phase signal are issued. These signals are signals for counting the number of (L·1) clocks. The reverse phase signal is issued as (L·1) count signal BRDYB becoming low level by noticing counting of the number of (L-1) clocks. The flip-flop circuit 1 composes the (L-n) detector.

The in-phase signal becoming high level by noticing counting of the number of (L-1) clocks is fed into one input terminal B of a selector 3. The other input terminal A of the selector 3 receives (L-2) count signal C. The select signal is operation mode signal S/D. It is high level in SDR mode as an example of first operation mode, and input terminal A is selected. It is low level in DDR mode as an example of second operation mode, and input terminal B is selected.

The output signal from the selector 3 is fed into input terminal D of a flip-flop circuit 5. Internal clock CKI is fed into clock terminal CK of the flip-flop circuit 5. The internal clock CKI is a clock functioning as synchronous signal in the synchronous storage device as described later. In SDR mode, a clock signal having same frequency as external clock CLK is issued. In DDR mode, a clock signal having double frequency of external clock CLK is issued. The former is first clock, and the latter is second clock. Validity flag RDY is issued from output terminal Q of the flip-flop circuit 5.

The validity flag (RDY) output unit is composed of selector 3 and flip-flop circuit 5, including the flip-flop circuit 1 for composing the (L·n) detector. The validity flag RDY is issued, whether in SDR mode or in DDR mode, in a period after edge of external clock CLK counting the L·1·th of number of clocks and before edge of L·th CLK, in the count period of initial latency (L).

That is, in SDR mode, (L-2) count signal C becoming high level by noticing counting of the number of (L-2) clocks is supplied from the selector 3 into input terminal D of flip-flop circuit 5. Later it is issued as validity flag RDY from internal clock CKI. In SDR mode, since the internal clock CKI is clock of same frequency as external clock CLK, the validity flag RDY is issued after counting of (L-1) clocks and before completion of counting of initial latency (L).

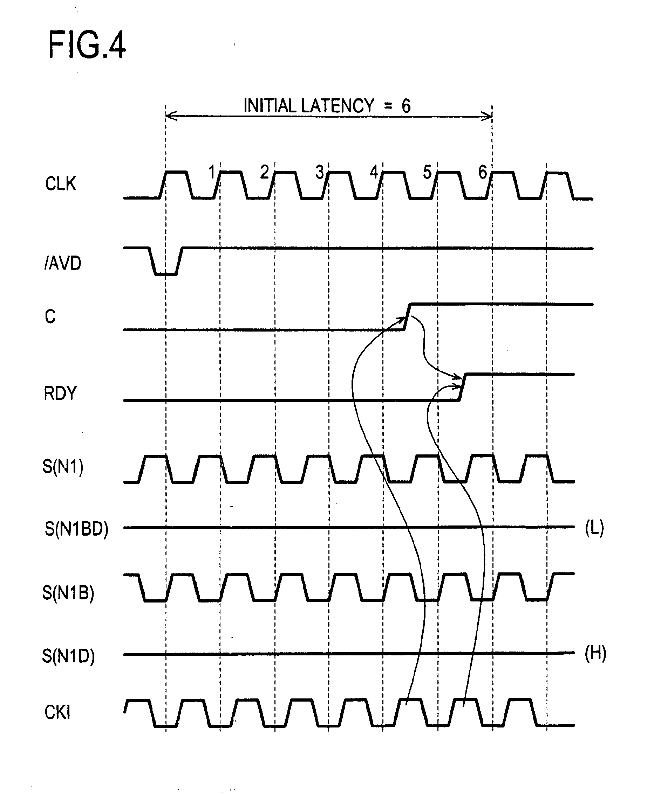

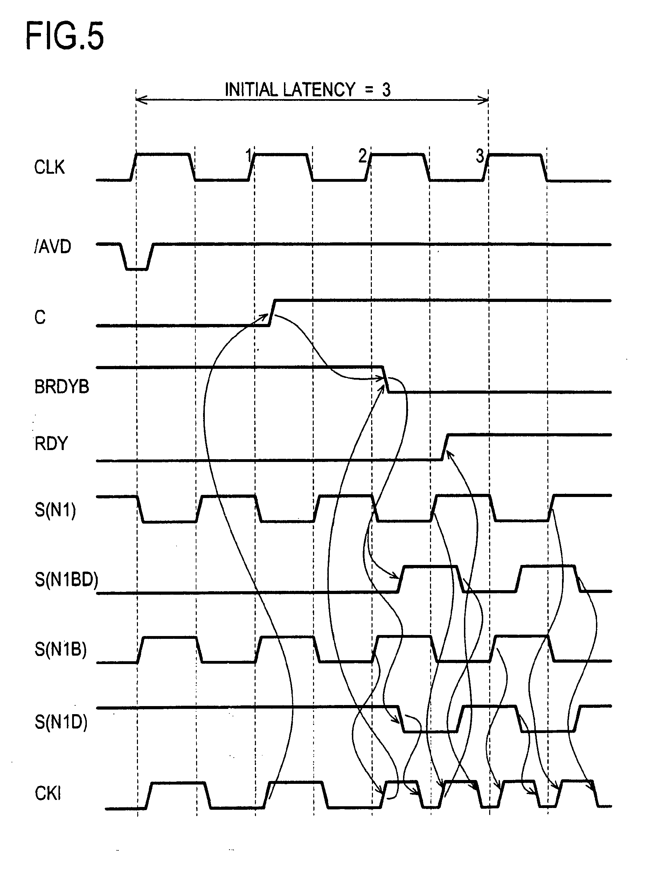

In DDR mode, signal becoming high level by noticing counting of the number of (L-1) clocks is supplied from the selector 3 into input terminal D of flip-flop circuit 5. Later it is issued as validity flag RDY from internal clock CKI. In DDR mode, the internal clock CKI is clock of double frequency of external clock CLK. By operating the internal clock CKI at double frequency depending on the (L-1) count signal BRDYB noticing counting of the number of (L-1) clocks, the validity flag RDY is issued in the second cycle of internal clock CKI changing over after counting of the number of (L-1) clocks, that is, in the latter half cycle of the final external clock CLK. This timing is before completion of counting of initial latency (L). Specific operation waveforms are explained later in Fig. 4 and Fig. 5.

The validity flag (RDY) output unit shown in Fig. 2 shows only an example, and the circuit configuration is not limited to Fig. 2. For example, same action and effect are obtained by connecting the output terminal Q of the flip-flop circuit 1 to the input terminal D of the flip-flop circuit 5, connecting the output terminal Q of the flip-flop circuit 1 and the output terminal Q of the flip-flop circuit 5 to the input terminals A and B of the selector 3, and issuing the validity flag RDY from the output terminal of the selector 3.

Further, as described below, depending on the definition of the validity flag (RDY), the value to be subtracted from the initial latency (L) may be a variable of n (n being 1 or greater), that is, (L-n).

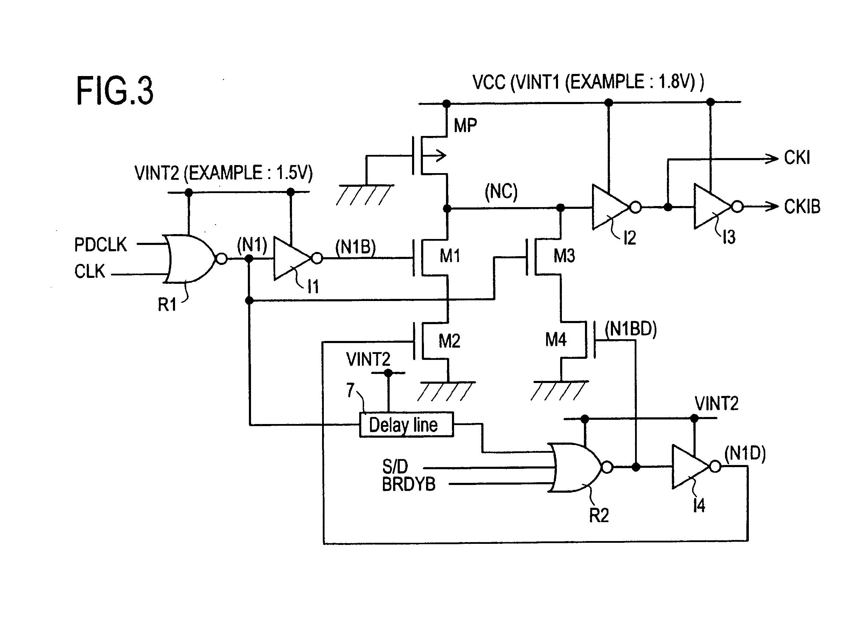

Fig. 3 shows an internal clock generator in the first embodiment. Two sets of transistor trains (M1 and M2, M3 and M4) connected in series between the output node NC and the grounding potential as lower reference potential compose first and second clock generators, together with the PMOS transistor MP as power supply unit for supplying higher supply voltage VCC (VINT1 described below) to the output node NC. The gate terminal of PMOS transistor MP is connected, for example, to the grounding potential and is always in conductive state, and charge is supplied to the output node NC. Between the first clock generator and second clock generator, the output node NC is commonly connected, and a common PMOS transistor MP is connected. The output node NC issues internal clock CKI by way of inverter gate 12, and is further inverted by inverter gate 13, and inverted internal clock CKIB is issued.

External clock CLK is fed into NOR gate R1 together with pause command signal PDCLK of external clock. When pause command signal PDCLK becomes high level and pause command is issued, external clock CLK is masked, and is not propagated inside. When pause command signal PDCLK is at low level, external clock CLK is inverted by way of NOR gate R1, and propagated inside. Inverted signal S (N1) of external clock CLK is propagated to node N1, and is fed into input terminal of inverter gate I1 and delay unit 7, and gate terminal of NMOS transistor M3. From output terminal of inverter gate 11, in-phase signal S (N1B) of external clock CLK is issued, and is put into gate terminal of NMOS transistor I1.

Inverter signal S (N1) entering the delay unit 7 is put into NOR gate R2 after being provided with specified delay time. The NOR gate R2 also receives operation mode signal S/D and (L-1) count signal BRDYB. When operation mode signal S/D is low level showing DDR mode, and in count period of initial latency (L), by counting the number of (L-1) clocks, after transition of (L-1) count signal BRDYB to low level, NOR gate R2 becomes logical inverted gate. In reverse phase to inverted signal S (N1), delayed signal S (N1BD) is sent into node N1BD. Node N1BD is connected to gate terminal of NMOS transistor M4. Further, signal S (N1BD) is inverted by inverter gate I4, and issued as signal S (N1D) into node N1D. Signal S (N1D) is in reverse phase of in-phase signal S (N1B) and is a delayed signal. Node N1D is connected to gate terminal of NMOS transistor M2.

In the first clock generator shown in Fig. 3, since the output node NC is charged to high level by PMOS transistor MP, in the period of conductive state of both NMOS transistors M1 and M2, and M3 and M4 in series connection for composing the transistor train, the output node NC is extracted to low level, and the internal clock CKI of high level is issued. When this period is over, the internal clock CKI is changed to low level.

Gate terminals of NMOS transistors M1 and M2 receive signal S (N1B) synchronized with one edge of external clock CLK, and delayed signal S (N1D) in reverse phase to signal S (N1B). Therefore, in the period from high level transition of signal S (N1B) to low level transition of signal S (N1D), transistors M1 and M2 are both in conductive state. Gate terminals of NMOS transistors M3 and M4 receive signal S (N1) synchronized with the other edge of external clock CLK, and delayed signal S (N1BD) in reverse phase to signal S (N1). Therefore, in the period from high level transition of signal S (N1) to low level transition of signal S (N1BD), transistors M3 and M4 are both in conductive state. This period is determined on the basis of the delay time given by the delay unit 7.

High level transition of signal S (N1B) is synchronized with high level transition of external clock CLK. High level transition of signal S (N1) is synchronized with low level transition of external clock CLK. Therefore, in the period of synchronizing with both edges of external clock CLK and nearly coinciding with the delay time given by the delay unit 7, the internal clock CKI changes to high level. Synchronizing with both edges of external clock CLK, pulse signal of high level is issued as internal clock CKI, and internal clock CKI becomes a clock of double frequency of external clock CLK.

In the case of setting of SDR mode (operation mode signal S/D is at high level), and/or when counting of initial latency (L) is less than the number of (L-1) clocks (when the (L·1) count signal BRDYB is at high level), the output signal of NOR gate R2 is fixed at low level. That is, signal S (N1BD) is fixed at low level, and signal S (N1D) is fixed at high level. NMOS transistor M4 is maintained in nonconductive state, and NMOS transistor M2 is maintained in conductive state. In this case, in the transistor train composed of transistors M1 and M2, depending on the conductive period of NMOS transistor M1, output node NC is extracted to low level, and its inverted signal, that is, internal clock CKI becomes high level. The conductive state of NMOS transistor M1 remains for the period of high level of signal S (N1B). That is, internal clock CKI clocks the time by synchronizing with external clock CLK. In SDR mode, and/or DDR mode, when counting of initial latency (L) is less than the number of (L-1) clocks, internal clock CKI is same frequency synchronized with external clock CLK.

Herein, the NOR gate R2 functions as first pause unit and signal mask unit. When set in SDR mode, and/or when counting of initial latency (L) is less than the number of (L-1) clocks, signal S (N1BD) is fixed at low level, and NMOS transistor M4 maintains in nonconductive state, and the second clock generator including NMOS transistors M3 and M4 comes to pause state. Further, signal S (N1D) is fixed at high level, and NMOS transistor M2 maintains in conductive state.

Ranks of elements are properly set in two sets of transistor trains (M1 and M2, M3 and M4) connected in series between the output node NC and grounding potential as lower reference potential. By contrast to Fig. 3, from the output node NC to the grounding potential as lower reference potential, NMOS transistors M2, M1 (M4, M3) may be connected sequentially. Considering from the characteristics of NMOS transistor, it seems better for the sake of high speed performance to transfer the NMOS transistor at output node NC side from nonconductive state to conductive state while the NMOS transistor at the lower reference potential side is in conductive state.

When set in SDR mode, and/or when counting of initial latency (L) is less than the number of (L-1) clocks, signal S (N1BD) is fixed at low level, and NMOS transistor M4 at output node NC side maintains in nonconductive state, and if NMOS transistor M3 at lower reference potential side is set in conductive state by signal S (N1), voltage fluctuations at output node NC side are small due to parasitic capacity between NMOS transistors M4 and M3, and operation is stable.

Elements composed of two sets of transistor trains (M1 and M2, M3 and M4) and PMOS transistor MP may also function as voltage level shifter. Interface voltages as signal voltage values of external terminals are determined by the system design other than the storage device, and there may be a difference from the internal operation voltage in the storage device. Preferably, the voltage conversion should be processed near the interface signal processing unit of each external terminal in the storage device. In this embodiment, as shown in Fig. 3, external clock CLK is converted in the voltage amplitude value of the signal, from internal voltage 2 (VINT2; for example, 1.5 V) conforming to interface voltage to internal voltage 1 (VINT1 ; for example, 1.8 V) as internal operation voltage, by voltage level shifter composed of two sets of transistor trains (M1 and M2, and M3 and M4) and PMOS transistor MP.

Fig. 4 and Fig. 5 are operation waveforms of internal clock generator (Fig. 3) in setting in SDR and DDR mode, respectively. Operation in each operation mode is explained by referring to Fig. 2 and Fig. 3.

In SDR mode (Fig. 4), the initial latency is 6 (L=6). When counting the number of 4 clocks subtracting 2 from the initial latency, (L-2) count signal C changes to high level. It is propagated to input terminal D of flip-flop circuit 5 by way of input terminal A of selector 3, and after cycle of 1 clock by internal clock CKI, validity flag RDY issued from output terminal Q is changed to high level.

Since operation mode signal S/D is at high level, output signal from NOR gate R2 is fixed at low level. NMOS transistor M4 is maintained in nonconductive state, and NMOS transistor M2 is maintained in conductive state. Internal clock CKI becomes high level depending on conductive period of NMOS transistor M1. Signal S (N1B) entering gate terminal is a signal in phase with external clock CLK, and internal clock CKI is issued as clock of same frequency as external clock CLK.

In DDR mode (Fig. 5), the initial latency is 3 (L=3). When counting the number of 1 clock subtracting 2 from the initial latency, (L-2) count signal C changes to high level same as in the case of SDR mode. The (L-2) count signal C entering the input terminal D of flip-flop circuit 1 is issued from output terminal D after cycle of 1 clock by external clock CLK, and is propagated to input terminal D of flip-flop circuit 5 by way of input terminal B of selector 3. After cycle of 1 clock by internal clock CKI, validity flag RDY issued from output terminal Q is changed to high level.

At this time, operation mode signal S/D is at low level. As (L-1) count signal BRDYB is inverted to low level by flip-flop circuit 1, NOR gate R2 functions as logical inversion gate. Delayed signal S (N1BD)/S (N1D) in reverse phase to signal S (N1)/S (N1B) is issued. A transistor train composed of NMOS transistors M1 and M2, and M3 and M4 conducts by synchronizing with both edges of external clock CLK, and internal clock CKI having double frequency of external clock CLK is issued.

Herein, the timing of (L-1) count signal BRDYB inverting to low level is the moment of counting the number of 2 clocks, subtracting 1 from the latency (3) in the counting period of initial latency. This is the start point of final external clock cycle in counting period of initial latency. Later, signal S (N1BD)/S (N1D) is issued. In the period from transition timing of various signals S (N1)/S (N1B) to high level, to transition timing of signal S (N1BD)/S (N1D), NMOS transistors M1 and M2, M3 and M4 for composing the transistor train conduct commonly, and the internal clock CKI is changed to high level.

It is a feature of the first aspect of the invention that the internal clock CKI has a double frequency in final external clock cycle in the count period of initial latency. In DDR mode, since data is read out depending on internal clock CKI of double frequency, and it is required not to recognize falsely that valid data is issued in synchronism with internal clock CKI in external clock cycle immediately before completion of counting of initial latency (before latency =2.5). Accordingly, waiting for second cycle (latency = 2.5) in internal clock CKI in external clock cycle immediately before completion of counting of initial latency, it is preferred to change the validity flag RDY to high level. Hence, at the moment of counting of initial latency (L = 3) and at edge point of first external clock reading out valid data, the validity flag RDY can be changed to high level.

If not necessary to change over SDR mode and DDR mode, in the internal clock generator in Fig. 3, by replacing the NOR gate R2 with an inverter gate for receiving a signal from the delay unit 7, a generating circuit of internal clock CKI corresponding to DDR mode can be composed.

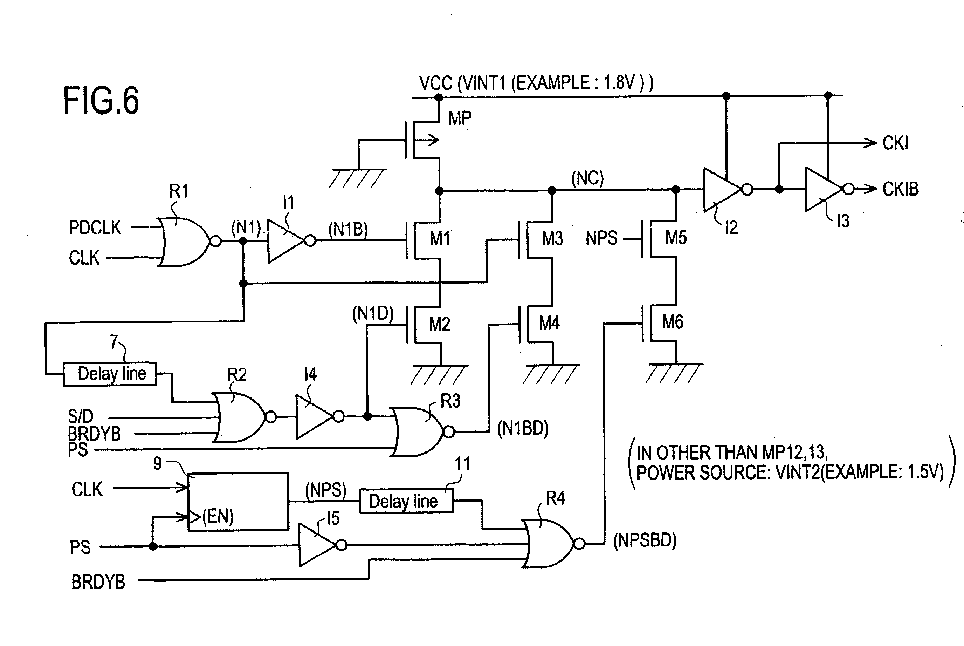

Fig. 6 shows an internal clock generator in second embodiment. The second embodiment is similar to the first embodiment, except that the internal clock generator further includes a function of detecting the half-period timing of external clock CLK regardless of time rate of period of high/low level of external clock CLK, and issuing a half-period signal S (NPS). In DDR mode, setting phase shift signal PS at low level, same as in the first embodiment, internal clock CKI of double frequency can be issued by synchronizing with both edges of external clock CLK. Further, by setting the phase shift signal PS at high level, it is also possible to issue internal clock CKI of double frequency dividing the period of external clock CLK precisely into two sections, regardless of edge timing of external clock CLK by making use of half-period signal S (NPS).

In the second embodiment, in addition to the internal clock generator of the first embodiment, two sets of NMOS transistor trains M5 and M6 are provided between the output node NC and grounding potential, and a fourth clock generator is composed together with PMOS transistor MP. In the second embodiment, two sets of NMOS transistor trains M1 and M2, M3 and M4 compose third and fifth clock generators.

The gate terminal of NMOS transistor M5 receives half-period signal S (NPS). The gate terminal of NMOS transistor M6 receives a delayed signal S (NPSBD) in reverse phase to half-period signal S (NPS). Half-period signal S (NPS) is issued from half-period notice unit 9. The half-period notice unit 9 is, for example, a DLL circuit, which receives an external clock CLK, and when phase shift signal PS fed in enable terminal EN is at high level, half-period signal S (NPS) is issued in node NPS at high precision. Half-period signal S (NPS) is put into gate terminal of NMOS transistor M5, and is also put into NOR gate R4 by way of delay unit 11. The NOR gate R4 receives phase shift signal PS after being inverted by inverter gate 15, and also receives operation mode signal S/D and (L-1) count signal BRDYB. The NOR gate R4 issues signal S (NPSBD).

In the first embodiment, output terminals of NOR gate R2 and inverter gate 14 in the internal clock generator are node N1BD and node N1D, and herein, instead, the output terminal of inverter gate 14 is connected to the gate terminal of NMOS transistor M2 as node N1D. Further having NOR gate R3, node N1D is connected to its input terminal, and phase shift signal PS is entered.

Same as the first pause unit and signal mask unit of the first embodiment, the NOR gate R2 functions as second pause unit and signal mask unit. The NOR gate R4 functions as third pause unit.

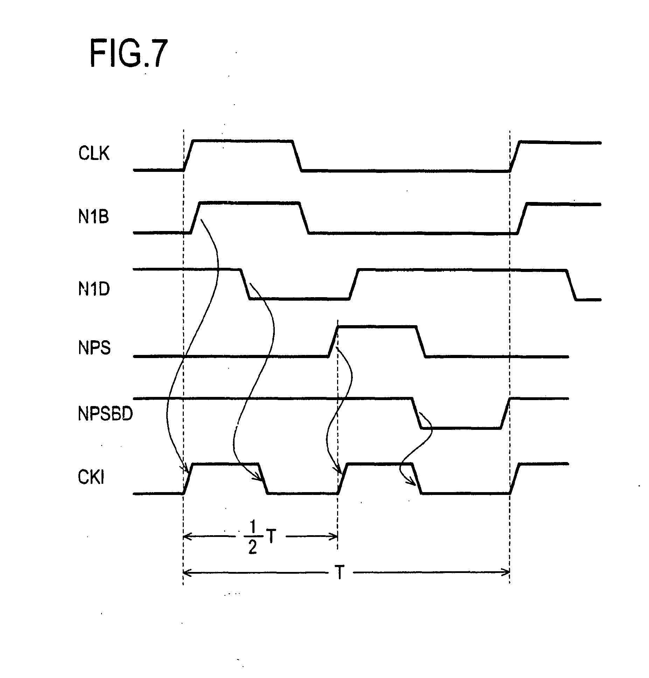

Operation of transistor trains (M1 and M2, M3 and M4) composing the third and fifth clock generators is same as operation of transistor trains (M1 and M2, M3 and M4) composing the first and second clock generators of the first embodiment, and the explanation is omitted herein. Operation waveforms of signal S (NPS) and signal S (NPSBD) for conducting and controlling the transistor train (M5 and M6) for composing the fourth clock generator are same as operation waveforms of signal S (N1B) and signal S (N1D) as shown in Fig. 7. The operation of transistor train (M5 and M6) for composing the fourth clock generator is also same as the operation of transistor train (M1 and M2) for composing the first clock generator in the first embodiment.

The half-period notice unit 9 issues signal S (NPS) precisely at the timing of half period T/2, in period T of external clock CLK. Regardless of time rate of period of high and low level of external clock, period T is equally divided into two sections, and internal clock CKI of double frequency can be issued. In DDR mode operating in synchronization with internal clock CKI of double frequency, the setup time and hold time of internal clock CKI can be reserved to the maximum extent, and a maximum operation allowance is assured.

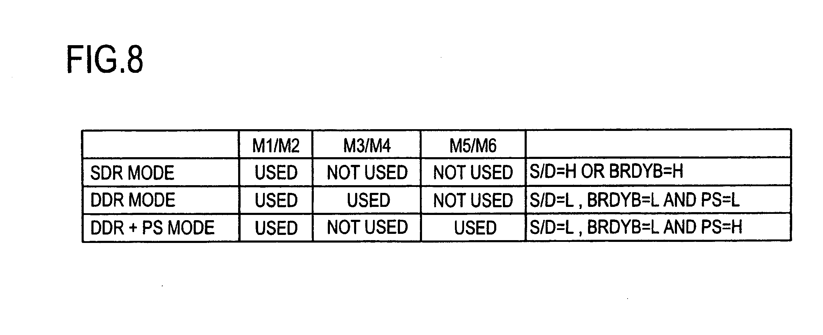

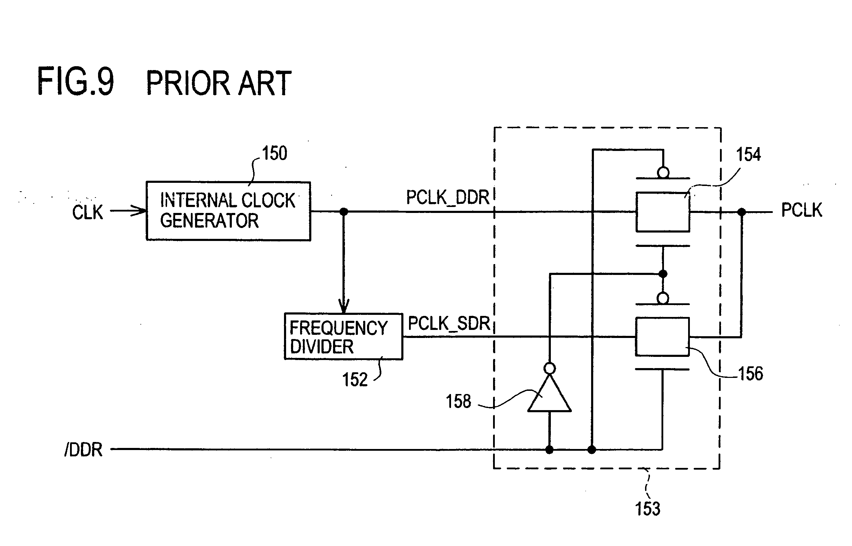

In the second embodiment, as shown in Fig. 8, by selecting the transistor train to be used in every mode of action, a desired internal clock CKI can be obtained. Because of logical sum composition wiring and coupling on the output node NC, the transistor train to be used may be easily selected.

When operation mode signal S/D or (L-1) count signal BRDYB is high level, transistor train (M1 and M2) is selected. NMOS transistor M2 is maintained in conductive state, and the transistor train (M1 and M2) is conducted and controlled at same frequency as external clock CLK. At this time, transistor trains (M3 and M4, M5 and M6) are in nonconductive state. Internal clock CKI corresponding to SDR mode can be generated.

When operation mode signal S/D, (L-1) count signal BRDYB, and phase shift signal PS are all at low level, transistor trains (M1 and M2, M3 and M4) are selected. The transistor train (M1 and M2) and transistor train (M3 and M4) are conducted and controlled in synchronization with one and other edges of external clock CLK respectively. At this time, transistor train (M5 and M6) is in nonconductive state. Internal clock CKI can be generated in synchronization with both edges of external clock CLK. Internal clock CLI corresponding to DDR mode is generated.

When operation mode signal S/D and (L-1) count signal BRDYB are at low level, and phase shift signal PS is at high level, transistor trains (M1 and M2, M5 and M6) are selected. The transistor train (M1 and M2) and transistor train (M5 and M6) are conducted and controlled in synchronization with one edge of external clock CLK, and one edge of half-period signal S (NPS), respectively. At this time, transistor train (M3 and M4) is in nonconductive state. Internal clock CKI can be generated in a period of dividing the period of external clock CLK precisely in two sections. Internal clock CLI corresponding to DDR mode is generated.

In the second embodiment, in DDR mode, transistor train (M3 and M4) and transistor train (M5 and M6) are selectively provided, but instead of transistor train (M3 and M4), transistor train (M5 and M6) may be provided.

If not necessary to change over SDR mode and DDR mode, in the internal clock generator in Fig. 6, instead of NOR gates R2, R4, an inverter gate for receiving signals from delay units 7, 11 may be provided, so that a generator of internal clock CKI corresponding to DDR mode can be composed. In this case, a basic clock generator is composed by including the transistor train (M1 and M2). Further, a first intermediate clock generator is composed by including the transistor train (M5 and M6). Moreover, a second intermediate clock generator is composed by including the transistor train (M3 and M4). Either one of the first intermediate clock generator and second intermediate clock generator is selected. Or if only either one is provided, internal clock CKI of double frequency can be generated.

The invention is not limited to these embodiments alone, but may be changed and modified in various forms within the scope not departing from the true spirit of the invention.

For example, in the validity flag (RDY) output unit shown in Fig. 2, external clock CLK is fed in the flip-flop circuit 1, and internal clock CKI is fed in the flip-flop circuit 5, but the invention is not limited to this example. The internal clock CKI may be fed in both flip-flop circuits 1 and 5.

In the internal clock circuit shown in Fig. 3 and Fig. 6, signal S (N1) is fed into the delay unit 7, but the invention is not limited to this example, and signal S (N1B) may be delayed.

Elements composed of three sets of transistor trains (M1 and M2, M3 and M4, M5 and M6) and PMOS transistor MP shown in Fig. 6 may also operate as voltage level shifter.

PMOS transistor MP as power supply source for supplying higher supply voltage VCC to output node NC shown in Fig. 3 and Fig. 6 is not limited to PMOS transistor alone, as far as it is an electrical resistance component. Not limited to transistor, it may be an element having an electrical resistance component.

In the first and second embodiments, when the second operation mode is set by detecting the number of (L-1) clocks subtracting 1 from the initial latency (L), depending on the detection signal of the number of (L-1) clocks, the internal clock CKI is changed over from the first clock synchronizing with either one edge of external clock CLK to second clock synchronizing with both edges of external clock CLK, but the subtracting number from the initial latency (L) is not limited to 1. That is, it may be (L-n) (n being 1 or greater). In this case, depending on the number of n, the flip-flop circuit 1 in Fig. 2 is increased.

For example, in DDR mode as an example of second operation mode, in the case of initial latency (L) = 4 and n = 2, by detecting the number of (L-2) clocks by subtracting 2 from the initial latency (L), when the second operation mode is set, by the internal clock generator, depending on the detection signal of number of (L-2) clocks, the internal clock CKI is changed over from the first clock synchronizing with either one edge of external clock CLK to second clock synchronizing with both edges of external clock CLK. Further, in the control method of synchronous storage device, when counting the initial latency (L) from start, the method comprises a step of detecting the number of (L-2) clocks subtracting 2 from the initial latency (L) concerning the external clock CLK, and a step of changing over the internal clock CKI from the first clock synchronizing with either one edge of external clock CLK to second clock synchronizing with both edges of external clock CLK, depending on the step of detecting the number of (L-2) clocks when the second operation mode is set. As a result, an optimum signal can be generated depending on the regulation of the validity flag (RDY).

The number of n is not limited to integer, and it may be, for example, 1.5. It means that the DDR mode is defined in latency in the unit of 0.5.

## Claims

1. A synchronous storage device capable of changing over between a first operation mode for accessing in synchronism with either edge of a pulse of an external clock signal and a second operation mode for accessing in synchronism with both edges of a pulse of the external clock signal, the synchronous storage device comprising:
an L-n detector for counting pulses of the external clock signal while counting the initial latency (L) from start of accessing, and detecting the number of pulses of the external clock signal (L-n) by subtracting n, wherein n is a numerical value of 1 or greater in increments of 0.5, from the initial latency (L); and
an internal clock generator coupled to the L-n detector for changing over an internal clock from a first clock signal for synchronizing with either edge of a pulse of the external clock signal to a second clock signal for synchronizing with both edges of a pulse of the external clock signal, depending on the detected signal from the L-n detector when the second operation mode is being set.

2. The synchronous storage device of claim 1 further comprising a validity flag output unit for issuing a data validity flag informing validity of output data depending on a second cycle of the second clock signal in the second operation mode.

3. The synchronous storage device of claim 2 wherein the validity flag output unit includes a flip-flop circuit for receiving the detection result from the L-n detector as an input signal, and using the second clock signal issued from the internal clock generator as a trigger signal in the second operation mode.

4. The synchronous storage device of claim 1 wherein the internal clock generator includes:
a first clock generator for issuing a pulse signal depending on a signal synchronizing with one edge of a pulse of the external clock signal and a delayed signal in reverse phase to the signal; and
a second clock generator for issuing a pulse signal depending on a signal synchronizing with the other edge of the pulse of the external clock and a delayed signal in reverse phase to the signal, and
wherein the first clock signal is generated depending on the pulse signal issued from the first clock generator, and the second clock signal is generated depending on the pulse signals issued from the first and second clock generators.

5. The synchronous storage device of claim 4 wherein the first and second clock generators include:
a power supply unit for supplying a high potential supply voltage to an output node; and
a transistor train having two NMOS transistors connected in series between the output node and a low reference potential, and
wherein a signal synchronizing with one edge of the external clock, a delayed signal in reverse phase to the signal, a signal synchronizing with the other edge of the external clock, and a delayed signal in reverse phase to the signal are connected to the gate terminal of each NMOS transistor of the transistor train.

6. The synchronous storage device of claim 5 wherein the power supply unit supplies a supply voltage at a voltage level different from a voltage level of a high level of the external clock signal.

7. The synchronous storage device of claim 5 wherein the output node is a common node between the first and second clock generators, and the power supply unit is commonly coupled to both the first and second clock generators.

8. The synchronous storage device of claim 5 further comprising a first pause unit for suspending the second clock generator in response to the detection signal not being issued from the L-n detector, or/and in response to the first operation mode.

9. The synchronous storage device of claim 8, wherein the first pause unit masks one of at least either the signal synchronizing with the other edge of the external clock or the delayed signal in reverse phase to the signal, and the first pause unit renders nonconductive at least one of the NMOS transistors comprising the transistor train of the second clock generator.

10. The synchronous storage device of claim 5 further comprising a signal mask unit for masking the delayed signal in reverse phase to the signal synchronizing with one edge of the external clock, and for maintaining the conductive state of the NMOS transistors comprising the transistor train of the first clock generator when the detection signal is not issued from the (L-n) detector, or/and during the first operation mode.

11. The synchronous storage device of claim 1 wherein the internal clock generator includes:
a third clock generator for issuing a pulse signal depending on a signal synchronizing with the one edge of the external clock and a delayed signal in reverse phase to the signal;
a half-period notice unit for issuing a half-period signal in response to detecting the timing of a half period from one edge of the external clock; and
a fourth clock generator for issuing a pulse signal in response to the half-period signal and a delayed signal in reverse phase to the half-period signal, and
wherein the first clock signal is generated depending on the pulse signal issued from the third clock generator, and wherein the second clock signal is generated depending on the pulse signals issued from the third and fourth clock generators.

12. The synchronous storage device of claim 11 wherein the third and fourth clock generators each include:
a power supply unit for supplying a high potential supply voltage to an output node of the third or fourth clock generators; and
a transistor train having two NMOS transistors connected in series between the output node and a low reference potential, and
wherein a signal synchronizing with the one edge of the external clock, a delayed signal in reverse phase to the signal, the half-period signal, and a delayed signal in reverse phase to the half period signal are supplied to the gate terminal of each NMOS transistor of the transistor train.

13. The synchronous storage device of claim 12 wherein the power supply unit supplies a different voltage level from the voltage level of a high level of the external clock signal.

14. The synchronous storage device of claim 12 wherein the output node is a common node between the third and fourth clock generators, and the power supply unit is commonly coupled to both the third and fourth clock generators.

15. The synchronous storage device of claim 12 further comprising a second pause unit for suspending the fourth clock generator when the detection signal is not issued from the (L-n) detector, or/and during the first operation mode.

16. The synchronous storage device of claim 15 wherein the second pause unit suspends the half-period notice unit, and/or masks at least one of the half-period signal and the delayed signal in reverse phase to the half-period signal, while rendering at least one of the NMOS transistors comprising the transistor train of the fourth clock generator nonconductive.

17. The synchronous storage device of claim 12, further comprising a signal mask unit for masking the delayed signal in reverse phase to the signal synchronizing with the one edge of the external clock, and maintaining the conductive state of the NMOS transistors comprising the transistor train of the third clock generator when the detection signal is not issued from the (L-n) detector, or and during the first operation mode.

18. The synchronous storage device of claim 11 further comprising:
a fifth clock generator for issuing a pulse signal depending on a signal synchronizing with the other edge of the external clock and a delayed signal in reverse phase to the signal,
wherein the second clock is generated by selection of a pulse signal issued from either the fourth or the fifth clock generator.

19. The synchronous storage device of claim 18 wherein the fifth clock generator includes :
a power supply unit for supplying a high potential supply voltage to the output node; and
a transistor train having two NMOS transistors connected in series between the output node and a low reference potential; and
a signal synchronizing with the other edge of the external clock and a delayed signal in reverse phase to the signal are connected to the gate terminal of each NMOS transistor of the transistor train.

20. The synchronous storage device of claim 18 wherein the output node is a common node among the third, the fourth and the fifth clock generators, and the power supply unit is commonly coupled to the third, the fourth and the fifth clock generators.

21. The synchronous storage device of claim 19, further comprising a third pause unit for suspending the fifth clock generator when the detection signal is not issued from the L-n detector, or/and during the first operation mode.

22. The synchronous storage device of claim 21 wherein the third pause unit suspends the signal synchronizing with the other edge of the external clock and masks at least one of the signal synchronizing with the other edge of the external clock, and the delayed signal in reverse phase to the signal, and renders at least one of the NMOS transistors comprising the transistor train of the fifth clock generator nonconductive.

23. A synchronous storage device for accessing in synchronism with both edges of an external clock comprising:
a basic clock generator for issuing a pulse signal in response to a signal synchronizing with one edge of the external clock and a delayed signal in reverse phase to the signal;
a half-period notice unit for issuing a half-period signal by noticing the timing of a half period from one edge of the external clock; and
a first intermediate clock generator for issuing a pulse signal in response to the half-period signal and a delayed signal in reverse phase to the half-period signal,
wherein a second clock signal is generated in response to the pulse signals issued from the basic clock generator and the first intermediate clock generator.

24. The synchronous storage device of claim 23 further comprising a second intermediate clock generator for issuing a pulse signal in response to a signal synchronizing with the other edge of the external clock and a delayed signal in reverse phase to the signal,
wherein the second clock signal is generated by selection of a pulse signal issued from either the first intermediate clock generator or the second intermediate clock generator.

25. A control method of a synchronous storage device capable of switching between a first operation mode for accessing in synchronism with either edge of an external clock signal and a second operation mode for accessing in synchronism with both edges of the external clock signal, the control method comprising the steps of:
detecting the number of clock signals (L-n), by subtracting n (n having a numerical value of 1 or higher at increments of 0.5) from the initial latency (L), about the external clock signal, the initial latency (L) being counted from start; and
in the second operation mode, changing over the internal clock from a first clock signal for synchronizing with either edge of the external clock signal to a second clock signal for synchronizing with both edges of the external clock signal in response to the step of detecting the number of clock signals (L-n).

26. The control method of the synchronous storage device of claim 25 further comprising the step of noticing validity of output data in response to a second cycle after the internal clock is changed over to the second clock signal in the second operation mode.

27. The control method of the synchronous storage device of claim 25 wherein the step of changing over the internal clock from the first clock signal to the second clock signal includes the steps of:
generating the internal clock signal by generating a pulse signal in response to a signal synchronizing with one edge of the external clock signal and a delayed signal in reverse phase to the signal and further including the steps of :
when changing over the internal clock,
generating a pulse signal and adding to the internal clock signal, in response to a signal synchronizing with other edge of the external clock and a delayed signal in reverse phase to the signal.

28. The control method of the synchronous storage device of claim 27 wherein the step of shifting a voltage level from a voltage amplitude value of the external clock signal is included in the step of the internal clock signal by generating a pulse signal in response to a signal synchronizing with one edge of the external clock and a delayed signal in reverse phase to the signal, and the step of generating a pulse signal and adding to the internal clock signal in response to a signal synchronizing with the other edge of the external clock signal and a delayed signal in reverse phase to the signal.

29. The control method of the synchronous storage device of claim 25, wherein the step of changing over the internal clock from the first clock to the second clock includes the steps of:
obtaining the internal clock signal by generating a pulse signal in response to a signal synchronizing with one edge of the external clock signal and a delayed signal in reverse phase to the signal, and further including the steps of:
when changing over the internal clock,
determining the timing of a half period from one edge of the external clock; and
generating a pulse signal and adding to the internal clock signal in response to the signal obtained by the step of noticing the timing of the half period and a delayed signal in reverse phase to the signal.

30. The control method of the synchronous storage device of claim 29, further comprising the steps of:
generating a pulse signal and adding to the internal clock signal in response to a signal synchronizing with the other edge of the external clock signal and a delayed signal in reverse phase to the signal; and
selecting either generating a pulse signal and adding to the internal clock signal step in response to a signal obtained at the step of noticing the timing of the half period and a delayed signal in reverse phase to the signal.

31. A control method of a synchronous storage device for accessing in synchronism with both edges of an external clock, the control method comprising the steps of :
obtaining an internal clock signal by generating a pulse signal depending on a signal synchronizing with one edge of the external clock and a delayed signal in reverse phase to the signal;
noticing the timing of a half period from one edge of the external clock ; and
generating a pulse signal and adding to the internal clock signal in response to a signal obtained at the step of noticing the timing of the half period and a delayed signal in reverse phase to the signal.

32. The control method of the synchronous storage device of claim 31 further comprising the steps of:
generating a pulse signal and adding to the internal clock in response to a signal synchronizing with the other edge of the external clock and a delayed signal in reverse phase to the signal; and
selecting either generating a pulse signal step in response to a signal obtained during the step of noticing the timing of the half period and a delayed signal in reverse phase to the signal.
